# EUROPEAN PATENT APPLICATION

(11) **EP 2 098 713 A1**
(43) Date of publication of application: **09.09.2009**
(21) Application number: 08102333.5
(22) Date of filing: 06.03.2008
(51) Int. Cl.: F02F 1/16

(54) **Thermoelectric heat recuperation system**

(71) Applicant: Iveco Motorenforschung AG, 9320 Arbon (CH)
(72) Inventor: Gstrein, Wolfgang, 9320, Arbon (CH)
(74) Representative: Borsano, Corrado

(57) **Abstract**

This invention concerns a thermoelectric heat recuperation system particularly for internal combustion engines. The system according to the present invention, suitable to transform the heat produced by the engine into electric current, is characterized by the fact that the thermoelectric element is positioned close to the cylinder liner, so assuring an increased efficiency of the heat recuperation.

## Description

The present invention concerns a system for recovering electric energy during the functioning of an internal combustion engine.

As it is known, it is possible to recover electric energy from the heat generated by the engine. In particular, it is known to recover electric energy by means of the application of thermoelectric elements in the exhaust stream or in the cooling system. These known system require the presence of a secondary heat exchanger in order to increase the efficiency of the thermoelectric element.

The presence of the secondary heat exchanger is one of the drawbacks of the known systems because it limits the efficiency of the thermoelectric heat recuperation.

Moreover, the presence of the additional heat exchanger contributes to increase the backpressure of the engine and, consequently, the fuel consumption.

The aim of the present invention is to eliminate or reduce the drawbacks afflicting the known thermoelectric heat recuperation methods.

Within this aim, it is an object of the present invention to provide a thermoelectric heat recuperation system with increased efficiency.

Another object of the present invention is to provide a thermoelectric heat recuperation system suitable to avoid the use of additional elements such as the secondary heat exchanger.

Moreover, it is an object of the present invention to reduce the load of the engine and, therefore, to reduce the fuel consumption.

This aim, and these objects of the present invention are achieved by a thermoelectric heat recuperation system particularly for internal combustion engines, comprising at least one thermoelectric element and at least an electric power circuit, characterized in that said at least one thermoelectric element is positioned close to the cylinder liner of at least one of the engine cylinders in order to convert into electric current the heat of the internal combustion engine.

Further advantages of the present invention will become clear from the following detailed description of a preferred embodiment and the drawings that are attached hereto, which are merely illustrative and not limitative of the present invention, in which:

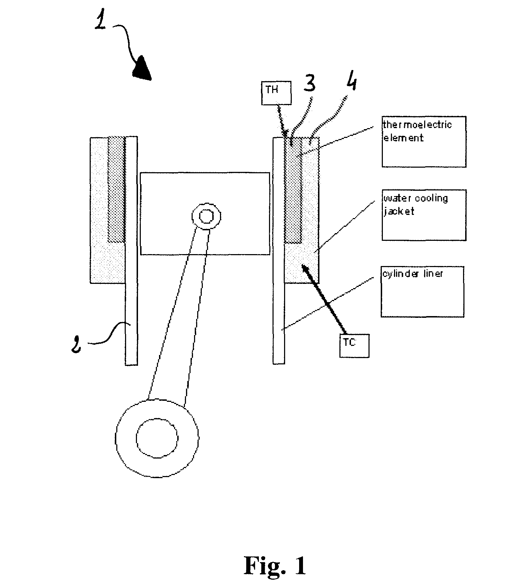

figure 1 schematically represents a cross-section view of a cylinder of an internal combustion engine provided with a thermoelectric element according to the thermoelectric heat recuperation system of the present invention.

With reference to figure 1, the thermoelectric heat recuperation system according to the present invention comprises at least a thermoelectric element 3 which is positioned near at least one of the cylinders of the internal combustion engine, the engine being generally indicated with reference number 1.

In particular, the thermoelectric element should be positioned around the cylinder. More in details, the thermoelectric element could be integrated in the casting of the internal combustion engine or it could be a part of an inserted cylinder liner assembly.

Advantageously, a series of elements to sum up to a suitable electric voltage is provided. Therefore, the inner and outer housing are electrically insulating, typically they consist of a ceramic plate. The inner ceramic housing could be a ceramic cylinder liner. The inner connections of the elements can be pressed or sintered or realized in any innovative way.

The elements can also be located at the other parts forming the boundary of the combustion chamber as the cylinder head or the piston.

As per figure 1, the thermoelectric insert is advantageously positioned close to the cylinder, more in particular it should contact or surround the cylinder liner.

In the embodiment shown in figure 1 as an example of the present invention, the thermoelectric element 3 is positioned between the cylinder liner 2 and the water cooling jacket 4. The temperature of the thermoelectric element on the hot side is indicated with T_{H}, while the temperature of the element on the water cooling jacket side is indicated with T_{C}.

With the positioning of the thermoelectric element close to the cylinder liner as per the present invention, it is not necessary to provide an auxiliary heat exchanger in order to dissipate the exceeding heat around the thermoelectric element. In fact, thanks to the presence of the water cooling jacket surrounding the thermoelectric element, no additional cooling system is necessary.

The thermoelectric element allows to recover electric energy from the heat generated by the engine. Then, the electric energy can be stored in a battery or directly used to provide electric power to the engine or to the vehicle's utilities in general. Thanks to the heat transfer from the cylinder, the loading of the engine cooling system is reduced, and this results in a further fuel consumption reduction. It has been shown that the present invention achieves the aim and the objects proposed.

More in detail, it has been shown that the thermoelectric heat recuperation system according to the present invention allows to avoid the presence of the auxiliary heat exchanger commonly used in the known systems in which thermoelectric elements are located in the exhaust stream or in the cooling system. As a consequence, the system according to the present invention allows to avoid the weight and the pressure losses in the exhaust coolant flow associated to the presence of the secondary heat exchanger.

Moreover, the system according to the present invention allows to reduce fuel consumption by means of the reduction of the loading of the engine cooling system. In fact, the heat is converted by the thermoelectric element immediately at the cylinder, so reducing the load of the engine cooling system and, therefore, reducing the fuel consumption.

It will be apparent to the person skilled in the art that other alternative and equivalent embodiments of the invention can be conceived and reduced to practice without departing from the true spirit of the invention.

From the description set forth above it will be possible for the person skilled in the art to embody the invention without introducing any further construction details.

## Claims

1. Thermoelectric heat recuperation system particularly for internal combustion engines (1), comprising at least one thermoelectric element (3) and at least an electric power circuit, **characterized in that** said at least one thermoelectric element (3) is positioned close to the cylinder liner (2) of at least one of the engine cylinders in order to convert into electric current the heat of the internal combustion engine.

2. Thermoelectric heat recuperation system according to claim 1, **characterized in that** said thermoelectric element (3) directly contacts the cylinder liner (2).

3. Thermoelectric heat recuperation system according to one of the previous claims, **characterized in that** said thermoelectric element (3) surrounds the cylinder liner (2).

4. Thermoelectric heat recuperation system according to one of the previous claims, **characterized in that** said thermoelectric element (3) is positioned between the cylinder liner (2) and the water cooling jacket (4) of the engine.

5. Internal combustion engine (1), **characterized in that** it comprises at least one thermoelectric element (3) positioned close to the cylinder liner (2).

6. Internal combustion engine (1) according to the preceding claim, **characterized in that** said thermoelectric element (3) contacts the cylinder liner (2).

7. Internal combustion engine (1) according to the preceding claim, **characterized in that** said thermoelectric element (3) is positioned between the cylinder liner (2) and the water cooling jacket (4).
